# EUROPÄISCHE PATENTSCHRIFT

(11) **EP 0 309 782 B1**
(45) Veröffentlichungstag und Bekanntmachung des Hinweises auf die Patenterteilung: **01.06.1994**
(21) Anmeldenummer: 88114535.3
(22) Anmeldetag: 06.09.1988
(51) Int. Cl.: H01L 21/306, H01L 21/38

(54) **Verfahren zum Ätzen von (100) Silizium**
Etching process for silicon (100)
Procédé d'attache du silicium (100)

(30) Priorität: 30.09.1987 DE 3733024
(43) Veröffentlichungstag der Anmeldung: 05.04.1989
(73) Patentinhaber: SIEMENS AKTIENGESELLSCHAFT, 80333 München (DE)
(72) Erfinder: Binder, Josef, Dr., Dipl. Phys., D-8127 Iffeldorf (DE); Ehrler, Günter, Dipl. Phys., D-8024 Deisenhofen (DE); Reichert, Hansjörg, Dr., Dipl. Phys., D-8000 München 90 (DE)

(56) Entgegenhaltungen:
- EP-A- 0 178 662
- DE-A- 2 031 333
- DE-A- 2 455 363
- DE-A- 2 551 444
- US-A- 3 642 593
- PROCEEDINGS OF THE 15TH IEEE PHOTOVOLTAIC SPECIALISTS CONFERENCE, 1981, Seiten 115-119, IEEE, New York, US; P.A. ILES et al.: "Silicon solar cells formed by orientation-dependent slicing"
- EXTENDED ABSTRACTS, Band 82-1, Mai 1982, Seiten 194-195; H. SEIDEL et al.: "Studies on the anisotropy and selectivity of etchants used for the fabrication of stress-free structures"

## Beschreibung

Die Erfindung betrifft ein Verfahren zum Ätzen von (100)-Silizium nach dem Oberbegriff des Anspruchs 1.

Bei Silizium-Membran-Drucksensoren ist es wichtig, daß eine Membranätzung so vorgenommen werden kann, daß beispielsweise eine Membran mit einer Dicke von 20 Micrometern zuverlässig, wohldefiniert und reproduzierbar hergestellt werden kann. Insbesondere soll ein solches Ätzverfahren die Herstellung eines preisgünstigen Silizium-Membran-Drucksensors für Massenherstellung ermöglichen. Beispielsweise könnte ein solcher Silizium-Membran-Drucksensor zur Herstellung eines preisgünstigen Barometers verwendet werden.

Mit Hilfe der Erfindung soll bei einem anisotropen (Kristallorientierten) Ätzen von Silizium-Scheiben ein exakter Ätzstopp erzielt werden.

Bislang bestand das anisotrope Ätzverfahren bei Silizium aus einem einzigen Ätzvorgang, z. B. einer alkalischen KOH-Ätzung, wobei als Ätzstopp eine hochdotierte Schicht oder ein in Sperr-Richtung gepolter pn-Übergang benutzt wurde. Der Ätzstopp liefert jedoch bei diesen bekannten Ätzverfahren relativ undefinierte und deutlich ungenaue Ergebnisse. Beim Ätzen einer Silizium-Scheibe diente bisher zur Abdeckung der Vorderseite der Silizium-Scheibe eine Nitridschicht, deren Entfernung nach dem Ätzvorgang problematisch ist.

Der vorliegenden Erfindung liegt die Aufgabe zugrunde, ein Verfahren der eingangs genannten Art anzugeben, mit dem bei einem anisotropen Ätzen von Silizium-Scheiben ein exakter Ätzstopp erzielt werden kann. Zusätzlich soll eine Maskierung für eine Silizium-Scheibe vorgeschlagen werden, die dieser erfindungsgemäßen Ätzung standhält.

Diese Aufgabe wird erfindungsgemäß durch ein Verfahren nach dem Anspruch 1 gelöst.

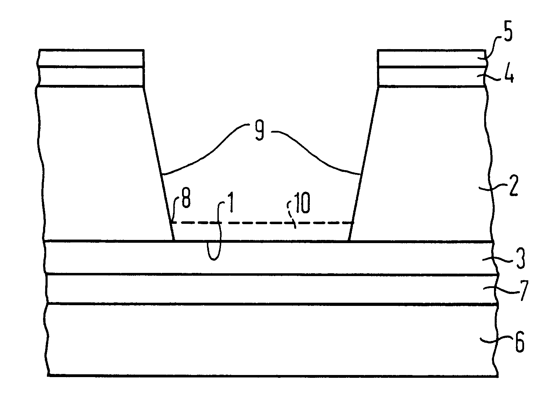

Ausgestaltungen und Vorteile der Erfindung sind in den Unteransprüchen, der Beschreibung und der Zeichnung angegeben.

Erfindungsgemäß wird auch eine Abdeckung für eine Siliziumscheibe vorgeschlagen, welche einer Ätzung nach dem Anspruch 1 standhält.

Das neue Ätzverfahren besteht aus
a) dem anisotropen Ätzen von (100)-Silizium mit Hilfe einer alkalischen KOH-Lösung als erstem Grob-Ätzschritt,
b) einem sich daran anschließenden elektrochemischen Ätzen in einer verdünnten Flußsäure (HF) als Fein-Ätzschritt, wobei die zu ätzende Silizium-Scheibe als Anode dient. Der exakte Ätzstopp wird bei einem Verfahren nach der Erfindung durch einen Übergang von einem niederohmigen Silizium-Substrat zu einer hochohmigen Epitaxie-Schicht, die eine gewünschte Dicke aufweist, realisiert.

Die Kombination aus den genannten beiden Ätzschritten zur Erzielung eines exakten Ätzstopps scheiterte bisher an dem Problem der Maskierung der Silizium-Scheibe mit einer Ätz-Maske.

Als Ätz-Maske dient erfindungsgemäß eine Zweifach-Schicht aus einem Oxid und einer über dem Oxid aufgebrachten Nitrid-Schicht.

Bisher war auch das Problem der Abdeckung der Vorderseite der Silizium-Scheibe nicht gelöst. Als Abdeckung der Vorderseite der Silizium-Scheibe, welche bereits mit fertigen elektronischen Bauelementen, insbesondere auch mit fertigen integrierten Schaltkreisen, versehen sein kann, wird eine Glasscheibe verwendet, die mit Hilfe eines Hochtemperatur-Wachses auf die Silizium-Scheibe aufgebracht wird.

Die Erfindung wird anhand der Zeichnung näher erläutert.

Die FIG zeigt schematisch einen Schnitt durch einen Silizium-Festkörper.

Die FIG zeigt schematisch (nicht maßstäblich) einen Teil einer Silizium-Scheibe, in dem eine Silizium-Membran für einen Silizium-Membran-Drucksensor hergestellt werden soll.

Der exakte Ätzstopp wird durch den Übergang 1 von dem niederohmigen Silizium-Substrat 2 zu einer hochohmigen Epitaxie-Schicht 3, welche eine gewünschte Dicke aufweist, gebildet.

Als Ätzmaske wird eine Zweifach-Schicht aus 120 Nanometer dickem thermischen Silizium-Dioxid 4 und 120 Nanometer dickem LP (Low Pressure)-CVD-Nitrid 5 vorgeschlagen. Diese Doppelschicht aus Nitrid 5 über Oxid 4 auf Silizium 2 hält beiden Ätzschritten als Ätzmaske stand.

Als Abdeckung der Vorderseite der Silizium-Scheibe, die bereits mit fertigen integrierten Schaltkreisen versehen sein kann, wird eine Glasscheibe (Tempax-Glas) 6 verwendet, die mit Hilfe eines Hochtemperatur-Wachses (sogenanntes "Optiker-Wachs") 7 auf die Silizium-Scheibe aufgebracht wird.

Das Ätzverfahren besteht aus dem anisotropen Ätzen des niederohmigen Substrats 2 mit Hilfe einer alkalischen KOH-Lösung als Grob-Ätzschritt im Bereich 9 des niederohmigen Siliziums 2 bis etwa zur Kante 8 innerhalb des niederohmigen Siliziums 2. Daran anschließend erfolgt im Bereich 10 des niederohmigen Siliziums 2 ein elektrochemisches Ätzen in einer verdünnten Flußsäure als Fein-Ätzschritt, wobei die zu ätzende Silizium-Scheibe als Anode dient. Der exakte Ätzstopp wird dabei durch den Übergang von dem niederohmigen Substrat 2 zu der hochohmigen Epitaxie-Schicht 3 realisiert. Die Dicke der Epitaxi-Schicht 3 bildet schließlich die Dicke der Membran des Silizium-Membran-Drucksensors.

## Patentansprüche

1. Verfahren zum Ätzen von einem niederohmigen (100)-Silizium-Substrat, das mit einer hochohmigen Epitaxie-Schicht versehen ist, wobei als Ätzmaske eine Siliziumnitrid-über-Siliziumoxid-Doppelschicht (4, 5) auf das niederohmige Substrat (2) aufgebracht wird, in einem ersten Grob-Ätzschritt das niederohmige Substrat (2) mit Hilfe einer alkalischen KOH-Lösung anisotrop bis an den Bereich (10) des Übergangs (1) vom niederohmigen Substrat (2) zur hochohmigen Epitaxie-Schicht (3) geätzt wird, und in einem zweiten Fein-Ätzschritt elektrochemisch bis an den Übergang (1) vom niederohmigen Substrat (2) zur hochohmigen Epitaxie-Schicht (3) geätzt wird, wobei die hochohmige Epitaxie-Schicht (3) als Ätzstopp dient.

2. Verfahren nach Anspruch 1, **dadurch gekennzeichnet,** daß zur Abdeckung der hochohmigen Epitaxie-Schicht (3) eine Glasscheibe (6) verwendet wird.

3. Verfahren nach Anspruch 2, **dadurch gekennzeichnet,** daß die Glasscheibe (6) mit Hilfe eines Hochtemperatur-Wachses (7) auf die hochohmige Epitaxie-Schicht (3) aufgebracht wird.

## Claims

1. Method for etching a low-resistance (100) silicon substrate which is provided with a high-resistance epitaxial layer, a silicon nitride over silicon oxide double layer (4, 5) being applied as etching mask to the low-resistance substrate (2), the low-resistance substrate (2) being etched in a first coarse etching step with the aid of an alkaline KOH solution anisotropically up to the region (10) of the transition (1) from the low-resistance substrate (2) to the high-resistance epitaxial layer (3) and in a second fine etching step being electrochemically etched up to the transition (1) from the low-resistance substrate (2) to the high-resistance epitaxial layer (3), the high-resistance epitaxial layer (3) being used as etching stop.

2. Method according to Claim 1, characterized in that a glass pane (6) is used for covering the high-resistance epitaxial layer (3).

3. Method according to Claim 2, characterized in that the glass pane (6) is applied to the high-resistance epitaxial layer (3) with the aid of a high-temperature wax (7).

## Revendications

1. Procédé de gravure d'un substrat de silicium (100) de faible valeur ohmique, qui est muni d'une couche épitaxiale de grande valeur ohmique, en déposant comme réserve de gravure sur le substrat (2) de faible valeur ohmique une couche double (4, 5) de nitrure de silicium sur oxyde de silicium, en gravant dans un premier stade grossier de gravure le substrat (2) de faible valeur ohmique à l'aide d'une solution alcaline de KOH de manière anisotrope jusqu'à la zone (10) de transition (1) du substrat (2) de faible valeur ohmique à la couche (3) épitaxiale de grande valeur ohmique, et en gravant dans un deuxième stade de gravure fin par voie électrochimique jusqu'à la transition (1) du substrat (2) de faible valeur ohmique à la couche (3) épitaxiale de grande valeur ohmique, la couche (3) épitaxiale de grande valeur ohmique servant d'arrêt de gravure.

2. Procédé suivant la revendication 1 caractérisé en ce qu'il consiste à utiliser une vitre (6) pour recouvrir la couche (3) épitaxiale de grande valeur ohmique.

3. Procédé suivant la revendication 2 caractérisé en ce qu'il consiste à appliquer la vitre (6) sur la couche (3) épitaxiale de grande valeur ohmique à l'aide d'une cire (7) haute température.
